# EUROPEAN PATENT SPECIFICATION

(11) **EP 3 276 694 B1**
(45) Date of publication and mention of the grant of the patent: **05.08.2026**
(21) Application number: 16768607.0
(22) Date of filing: 17.03.2016
(51) Int. Cl.: H10K 30/82, H10K 30/83, H10K 30/88, H10K 85/50, H10K 30/15, H10K 30/50

(54) **SOLAR CELL**
SOLARZELLE
PILE SOLAIRE

(30) Priority: 25.03.2015 JP 2015061966
(43) Date of publication of application: 31.01.2018
(73) Proprietor: Sekisui Chemical Co., Ltd., Osaka-shi, Osaka 530-8565 (JP)
(72) Inventor: ASANO, Motohiko, Mishima-gun Osaka 618-0021 (JP); HAYAKAWA, Akinobu, Mishima-gun Osaka 618-0021 (JP); FUKUMOTO, Yuuichirou, Mishima-gun Osaka 618-0021 (JP); OHARA, Shunji, Mishima-gun Osaka 618-0021 (JP); YUKAWA, Mayumi, Mishima-gun Osaka 618-0021 (JP); UNO, Tomohito, Mishima-gun Osaka 618-0021 (JP)
(74) Representative: Ter Meer Steinmeister & Partner
(86) International application number: PCT/JP2016/058458
(87) International publication number: WO 2016/152704

(56) References cited:
- WO-A1-2013/128932
- WO-A1-2013/128932
- WO-A2-2011/086500
- JP-A- 2005 332 705
- JP-A- 2011 155 155
- JP-A- 2011 155 155
- JP-A- 2014 056 921
- US-A1- 2013 004 753
- DANIEL BRYANT ET AL: "A Transparent Conductive Adhesive Laminate Electrode for High-Efficiency Organic-Inorganic Lead Halide Perovskite Solar Cells", ADVANCED MATERIALS, vol. 26, no. 44, 1 November 2014 (2014-11-01), DE, pages 7499 - 7504, XP055422409, ISSN: 0935-9648, DOI: 10.1002/adma.201403939
- DENNLER G ET AL: "A new encapsulation solution for flexible organic solar cells", THIN SOLID FILMS, ELSEVIER, AMSTERDAM, NL, vol. 511-512, 26 July 2006 (2006-07-26), pages 349 - 353, XP025007205, ISSN: 0040-6090, [retrieved on 20060726], DOI: 10.1016/J.TSF.2005.12.091
- JOEL TROUGHTON ET AL: "Highly efficient, flexible, indium-free perovskite solar cells employing metallic substrates", JOURNAL OF MATERIALS CHEMISTRY A, vol. 3, no. 17, 1 January 2015 (2015-01-01), GB, pages 9141 - 9145, XP055501698, ISSN: 2050-7488, DOI: 10.1039/C5TA01755F

## Description

### Technical Field

The present invention relates to a solar cell comprising a photoelectric conversion layer containing an organic-inorganic perovskite compound.

### Background Art

A solar cell having a photoelectric conversion layer containing an organic-inorganic perovskite compound has been known. For example, the following Patent Literature 1 discloses an example of such a solar cell. In this solar cell, a first electrode is provided on a substrate made of glass or the like. A photoelectric conversion layer including a layer containing an organic-inorganic perovskite compound as the main component is provided on the first electrode. A second electrode is formed on the photoelectric conversion layer. Perovskite solar cells are further known from Non-Patent Literature 1 and 3. Materials and manufacturing techniques that are useful in the production of solar cells can be found in Patent Literature 2 and 3 and Non-Patent Literature 2. An example for the setup of an organic thin film solar cell, in particular a dye sensitized solar cell, is given in Patent Literature 4.

### Citation List

### Patent Literature

Patent Literature 1: Japanese Patent Laid-Open No. 2014-72327
Patent Literature 2: US 2013/004753 A1
Patent Literature 3: WO 2011/086500 A2
Patent Literature 4: JP 2011 155155 A

### Non-Patent Literature

Non-Patent Literature 1: Bryant D et al. "A Transparent Conductive Adhesive Laminate Electrode for High-Efficiency Organic-Inorganic Lead Halide Perovskite Solar Cells", Adv. Mater., 2014, 26, pp. 7499-7504.
Non-Patent Literature 2: Dennler G et al. "A new encapsulation solution for flexible organic solar cells", Thin Solid Films, 2006, 511, pp. 349-353.
Non-Patent Literature 3: Troughton J et al. "Highly efficient, flexible, indium-free perovskite solar cells employing metallic substrates", J. Mater. Chem. A, 2015, 3, pp. 9141-9145.

### Summary of Invention

### Technical Problem

In a solar cell using an organic photoelectric conversion layer containing an organic-inorganic perovskite compound or the like, flexibility can be increased by using a flexible base material. On the other hand, when such a solar cell is exposed to external environment, it has sometimes been deteriorated, resulting in penetration of water from the electrode surface into the inner part. In addition, there has been a problem that the wirings for connecting to an external electrode are deteriorated by corrosion.

An object of the present invention is to provide a solar cell which is excellent in gas barrier properties and in which the deterioration of wirings does not easily occur.

### Solution to Problem

The above object is solved by the solar cell according to independent claim 1.

The solar cell according to the present invention comprises amongst others: a first electrode; a second electrode arranged so as to face the first electrode; a photoelectric conversion layer which is arranged between the first electrode and the second electrode and contains an organic-inorganic perovskite compound; a plurality of auxiliary wirings provided on the second electrode; a resin layer provided on the second electrode so as to fill a space between the plurality of auxiliary wirings; and an inorganic layer provided so as to cover the plurality of auxiliary wirings and the resin layer, wherein the thickness of the plurality of auxiliary wirings is larger than the thickness of the resin layer.

The solar cell further comprises a first terminal connected to the first electrode and a second terminal connected to the plurality of auxiliary wirings.

Furthermore, the inorganic layer is constituted by a conductive material, and the second terminal is provided on the inorganic layer.

In another specific aspect of the solar cell according to the present invention, the second electrode forms a laminated structure directly or indirectly laminated on the photoelectric conversion layer, and the solar cell further comprises an insulating layer provided so as to cover the outer peripheral surface of the laminated structure.

In a reference solar cell embodiment, which is not according to the present invention, a part of the plurality of auxiliary wirings reaches the upper surface of the insulating layer, and the second terminal is provided on the insulating layer through the auxiliary wirings.

In still another specific aspect of the solar cell according to the present invention, the organic-inorganic perovskite compound is represented by the general formula R-M-X₃, where R represents an organic molecule; M represents a metal atom; and X represents a halogen atom or a chalcogen atom.
In still another specific aspect of the solar cell according to the present invention, the resin layer contains a wiring corrosion inhibitor.

In still another specific aspect of the solar cell according to the present invention, the first electrode is constituted by metal foil.

In still another specific aspect of the solar cell according to the present invention, the solar cell further comprises an electron transport layer arranged between the first electrode and the photoelectric conversion layer and a hole transport layer arranged between the photoelectric conversion layer and the second electrode.

### Advantageous Effects of Invention

The present invention can provide a solar cell which is excellent in gas barrier properties and in which the deterioration of wirings does not easily occur.

### Brief Description of Drawings

[Figure 1] Figure 1 is a schematic sectional view showing the basic structure of the solar cell according to an embodiment of the present invention.
[Figure 2] Figure 2 is a schematic plan view showing, under magnification, the auxiliary wiring part of the solar cell of figure 1.
[Figure 3] Figure 3 is a schematic sectional view showing the solar cell according to an embodiment of the present invention.
[Figure 4] Figure 4 is a schematic sectional view showing the solar cell according to a reference embodiment, which is not according to the present invention.
[Figure 5] Figure 5 is a schematic plan view showing the auxiliary wiring part in a modification of the solar cell of figures 1 and 2.

### Description of Embodiments

Hereinafter, the present invention will be clarified by describing specific embodiments of the present invention with reference to drawings.

### (Basic structure of the Solar Cell)

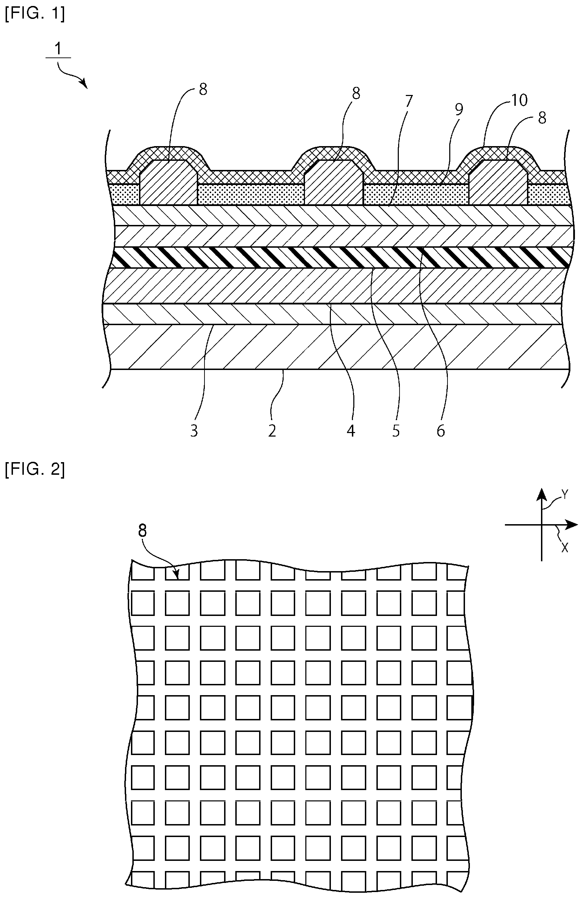

Figure 1 is a schematic sectional view showing the basic structure of the solar cell according to the present invention. Figure 2 is a schematic plan view showing, under magnification, the
auxiliary wiring part of the solar cell of figure 1.

As shown in Figure 1, a solar cell 1 comprises first and second electrodes 2 and 7, first and second electron transport layers 3 and 4, a photoelectric conversion layer 5, a hole transport layer 6, auxiliary wirings 8, a resin layer 9, and an inorganic layer 10.

The first electrode 2 is constituted by metal foil. A metal constituting the metal foil is not particularly limited, and a suitable metal or alloy such as stainless steel, Al, Cu, Ni, or Ti can be used. When metal foil is used, the flexibility of the solar cell 1 can be increased.

Note that the first electrode 2 is not limited to metal foil, but it may be prepared, for example, by providing a metal electrode on a resin film or a metal substrate. Examples of a material constituting the resin film include PET, PEN, polyimide, and polycarbonate. Examples of a material constituting the metal electrode include Al, Cu, Mo, Ni, Ti, Fe, and a laminate thereof. When the metal electrode is provided on a metal substrate, it is desirable to provide an insulating part between the metal substrate and the metal electrode. The same material as an insulating material to be described below can be used for a material used as the insulating part. Other materials that can be used will be described below.

The first and second electron transport layers 3 and 4 are provided on the first electrode 2. The first and second electron transport layers 3 and 4 may not be provided, but photoelectric conversion efficiency can be increased by providing the first and second electron transport layers 3 and 4.

The photoelectric conversion layer 5 is provided on the second electron transport layer 4. The photoelectric conversion layer 5 contains an organic-inorganic perovskite compound. In the solar cell 1, photoelectric conversion is performed by the organic-inorganic perovskite compound, and electric power is taken out.

The hole transport layer 6 is provided on the photoelectric conversion layer 5. The hole transport layer 6 may not be used.

The second electrode 7 is provided on the hole transport layer 6. The second electrode 7 is arranged so as to face the first electrode 2. Therefore, the first and second electron transport layers 3 and 4, the photoelectric conversion layer 5, and the hole transport layer 6 are arranged between the first and second electrodes 2 and 7. The first and second electron transport layers 3 and 4, the photoelectric conversion layer 5, and the hole transport layer 6 are laminated in this order from the electrode 2 side. The details of each layer will be described below.

The auxiliary wirings 8 and the resin layer 9 are provided on the second electrode 7. The lower end of the auxiliary wirings 8 is in contact with the upper surface of the second electrode 7 and electrically connected.

As shown in Figure 2, the auxiliary wirings 8 are formed by crossing a plurality of auxiliary wirings extending in the X direction and a plurality of auxiliary wirings extending in the Y direction which is orthogonal to the X direction, and they have a grid shape as a whole in the plane view. Note that the shape of the auxiliary wirings 8 is not particularly limited, but may be, for example, a plurality of line-shaped auxiliary wirings.

The material constituting the auxiliary wirings 8 is not particularly limited as long as it is a conductive material. However, a metal such as Cu, Al, and Ag or an alloy thereof is preferably used. The cost can be reduced by using such a metal or an alloy. Larger electric power can be taken out by reducing the electrical resistance of electric connection parts.

The resin layer 9 is provided so as to fill a space between the plurality of auxiliary wirings 8 extending in the X direction and the Y direction. When the plurality of auxiliary wirings 8 are provided so that the space therebetween is filled with the resin layer 9 (the resin layer 9 is compartmented), water hardly reaches the solar cell part below (particularly, the photoelectric conversion layer 5 containing an organic-inorganic perovskite compound to be described below) even if the water infiltrates into the resin layer from a defective part under the influence of foreign matter and the like.

More specifically, water having infiltrated into the resin layer 9 from the defective part of the inorganic layer 10 or the like diffuses in the resin layer 9, but since the resin layer 9 is compartmented by the auxiliary wirings 8, the water hardly diffuses into the adjacent resin layers 9. Therefore, unless there is a defect in the second electrode 7 in the same compartment as the inorganic layer 10 having a defect, water cannot easily infiltrate into the solar cell part (photoelectric conversion layer 5).

Since water cannot easily infiltrate into the solar cell part (photoelectric conversion layer 5), the durability of the solar cell 1 can be improved. That is, barrier properties to water and the like can be effectively increased. The thickness of the resin layer 9 is smaller than the thickness of the auxiliary wirings 8. In this case, the resin layer 9 can be compartmented much more easily.

The inorganic layer 10 is provided so as to cover the auxiliary wirings 8 and the resin layer 9. More specifically, the inorganic layer 10 covers the upper surface of the auxiliary wirings 8, a part of the side surface of the auxiliary wirings 8, and the upper surface of the resin layer 9. The inorganic layer 10 is excellent in barrier properties to water and the like. Therefore, the infiltration of water vapor and the like into the inner part can be effectively suppressed.

As the water vapor barrier properties of the inorganic layer 10, the water vapor transmission rate (WVTR) is desirably less than 10⁻¹ g/m²/day. The material constituting the inorganic layer 10 is a conductive material. Preferably it includes, for example, a metal oxide, a metal nitride, or a metal oxynitride. The metal in the metal oxide,
metal nitride, or metal oxide is not particularly limited, and examples of the metal include
Si, Al, Zn, Sn, In, Ti, Mg, Zr, Ni, Ta, W, Cu, and an alloy containing these metals as the main component. Among them, a metal oxide and a metal nitride each containing both Zn and Sn are preferred because they are excellent in water vapor barrier properties and flexibility.

In the solar cell 1, the infiltration of water into the solar cell part below can be reliably suppressed by providing the inorganic layer 10.

In the solar cell 1, the corrosion of the auxiliary wirings 8 by deterioration can be suppressed because the auxiliary wirings 8 are covered with the inorganic layer 10.

Particularly, as in the present embodiment, when the upper surface to a part of the side surface of the auxiliary wirings 8 are covered with the inorganic layer 10, the deterioration of the auxiliary wirings 8 can be much more suppressed.

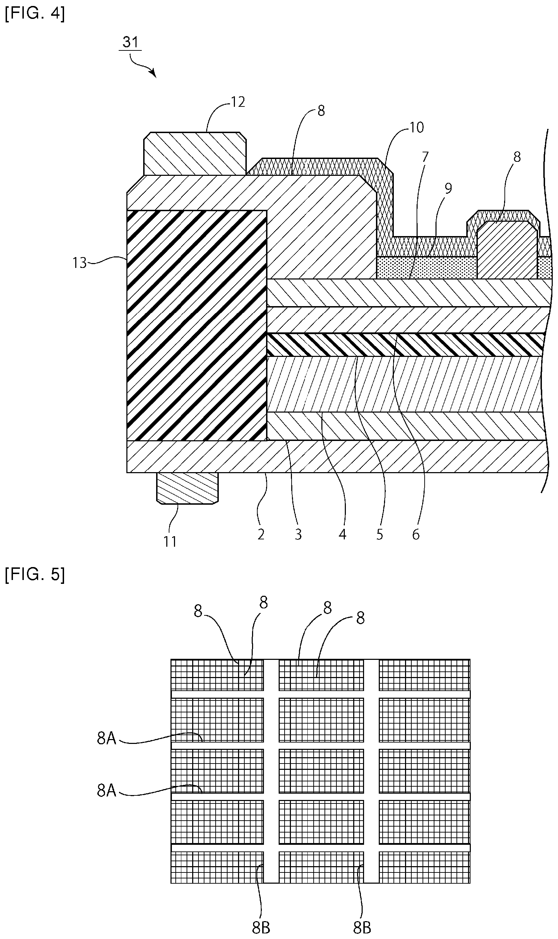

Figure 5 is a schematic plan view showing the auxiliary wiring part in a modification of the solar cell of figures 1 and 2. In this modification, plural types of
auxiliary wirings 8, 8A, and 8B are provided. That is, the auxiliary wirings
8 each having a small width are arranged in a grid as in figures 1 and 2. The auxiliary wirings 8A each having a larger width than that of the auxiliary wirings 8 are provided so as to extend in the lateral direction in Figure 5. A plurality of the auxiliary wirings 8B each having a larger width than that of the auxiliary wirings 8A extend in the direction crossing the auxiliary wirings 8A.

Thus, in the present invention, plural types of auxiliary wirings 8, 8A, and 8B having different widths may be provided. In this case, these auxiliary wirings are not limited to those having different widths, but plural types of auxiliary wirings having different heights may be used. Further, plural types of auxiliary wirings which are different in both width and height or thickness may be used.

### (Embodiment of the Solar Cell)

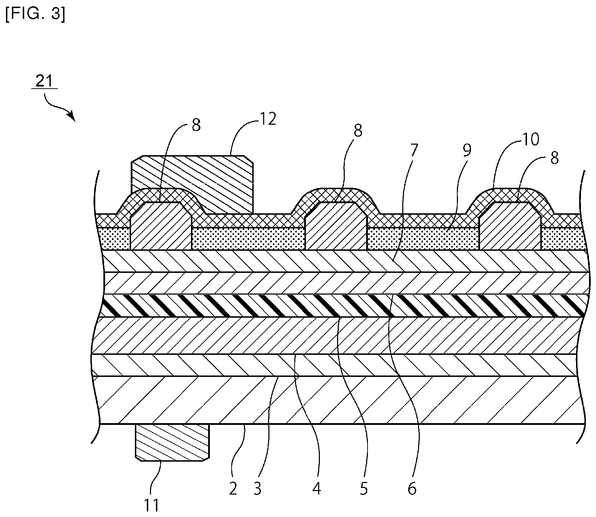

Figure 3 is a schematic sectional view showing the solar cell according to an embodiment of the present invention. As shown in Figure 3, in a solar cell 21, the second terminal 12 is joined to the inorganic layer 10. The second terminal 12 is provided above the part where a part of the auxiliary wirings 8 and the resin layer 9 are provided. A first terminal 11 is provided under the part where the second terminal 12 is
provided. The first terminal 11 is electrically joined to the first electrode 2. In this case, the first terminal may be extended to serve as the second terminal of another solar cell connected. The first terminal 11 may not be provided, but the first electrode 2 itself may be electrically connected to the outside.

In the solar cell 21, the inorganic layer 10 is constituted by a conductive material. Examples of the conductive material include, but are not particularly limited to, ITO, ZnO, Al, ZnO doped with Ga or In, SnO, and ZnSnO. These may be used singly or in combination. Other points are the same as those described in relation to figures 1, 2 and 5 before.

Also in the embodiment according to the present invention, water cannot easily infiltrate into the inner part of the solar cell 21 because the second electrode 7 is covered with the resin layer 9 and the inorganic layer 10. Therefore, the solar cell 21 is excellent in barrier properties such as gas barrier properties.

In the solar cell 21, the auxiliary wirings 8 are covered with the inorganic layer 10. Therefore, also in the solar cell 21, the deterioration by the corrosion of the auxiliary wirings 8 can be suppressed.
Further in the embodiment according to the present invention, the inorganic layer 10 is constituted by a conductive material, and the second terminal 12 is provided on the inorganic layer 10. Therefore, the second terminal 12 and the auxiliary wiring 8 are electrically connected. Since the second terminal 12 is provided above the auxiliary wiring 8, light is hardly intercepted, and sufficient light can be introduced into the photoelectric conversion layer 5.

### (Reference Embodiment)

Figure 4 is a schematic sectional view showing the solar cell according to a reference embodiment, which is not according to the present invention.

As shown in Figure 4, in a solar cell 31, an insulating layer 13 is provided so as to seal the outer side surface of the solar cell 31. Thus, since the solar cell 31 has excellent sealing properties, the elution of Pb ions to the outside hardly occurs even if an organic-inorganic perovskite compound contains Pb. Therefore, it is appropriate as long as the insulating layer 13 covers at least the photoelectric conversion layer 5.

The insulating material constituting the insulating layer 13 is not particularly limited. That is, an organic insulating material may be used. An inorganic insulating material may also be used. Examples of such an inorganic insulating material include inorganic oxides such as SiO₂, Al₂O₃, and ZrO, glass, and Claist. An organic insulating material may be used as long as it has sufficiently satisfactory heat resistance. Examples of such an organic insulating material include thermosetting polyimide and the like.

As shown in Figure 4, a part of the auxiliary wirings 8 is provided so as to reach the upper end and the side surface of the insulating layer 13. As shown in Figure 4, the lower end of the auxiliary wirings 8 is in contact with the upper surface of the second electrode 7 and electrically connected.

In a part of the auxiliary wirings 8 provided at the upper end of the insulating layer 13, the inorganic layer 10 is removed. The second terminal 12 is joined to the part of the auxiliary wirings 8 exposed by removing the inorganic layer 10. Note that the second electrode 7 may be arranged between the insulating layer 13 and the auxiliary wirings 8.

On the other hand, as shown in Figure 4, the first terminal 11 is provided under the part where the second terminal 12 is provided. The first terminal 11 is electrically joined to the first electrode 2. Other points are the same as those described in relation to figures 1, 2 and 5 before.

Also in the reference embodiment, water cannot easily infiltrate into the inner part from the electrode surface because the second electrode 7 is covered with the resin layer 9 and the inorganic layer 10. Therefore, the solar cell 31 is excellent in barrier properties such as gas barrier properties.

In the solar cell 31, the auxiliary wirings 8 are covered with the isnorganic layer 10. Therefore, the deterioration by the corrosion of the auxiliary wirings 8 can be suppressed.

Further in the reference embodiment, a part of the auxiliary wirings 8 is provided at the upper end of the insulating layer 13, and the second terminal 12 is provided on the auxiliary wiring 8. Therefore, even if the second terminal 12 is provided, light is not intercepted, and sufficient light can be introduced into the photoelectric conversion layer 5.

Hereinafter, the details of each component constituting each layer of the solar cell according to the present invention will be described.

### First and Second Electrodes;

The first and second electrodes may be formed using a suitable conductive material. Examples of such a material include metals such as FTO (fluorine-doped tin oxide), sodium, a sodium-potassium alloy, lithium, magnesium, aluminum, a magnesium-silver mixture, a magnesium-indium mixture, an aluminum-lithium alloy, an Al/Al₂O₃ mixture, an Al/LiF mixture, and gold; conductive transparent materials such as CuI, ITO (indium tin oxide), SnO₂, AZO (aluminum zinc oxide), IZO (indium zinc oxide), and GZO (gallium zinc oxide); conductive transparent polymers; and metal foil. These materials may be used singly or in combination of two or more kinds thereof. The first electrode is preferably metal foil.

The second electrode is desirably transparent. Thereby, sufficient light can be introduced into the photoelectric conversion layer. Consequently, for the second electrode, it is desirable to use an electrode material excellent in transparency, such as ITO.

### First and Second Electron Transport Layers;

Examples of the material for the first and second electron transport layers include, but are not particularly limited to, an N-type conductive polymer, an N-type low-molecular organic semiconductor, an N-type metal oxide, an N-type metal sulfide, an alkali metal halide, an alkali metal, and a surfactant. Specific examples include cyano group-containing polyphenylene vinylene, a boron-containing polymer, bathocuproine, bathophenanthrene, hydroxyquinolinato aluminum, an oxadiazole compound, a benzimidazole compound, a naphthalene tetracarboxylic acid compound, a perylene derivative, a phosphine oxide compound, a phosphine sulfide compound, fluoro group-containing phthalocyanine, titanium oxide, zinc oxide, indium oxide, tin oxide, gallium oxide, tin sulfide, indium sulfide, and zinc sulfide.

The first electron transport layer may be used, but it is much more preferred to provide a porous second electron transport layer. Particularly, when the photoelectric conversion layer is a composite film in which the organic semiconductor or inorganic semiconductor region forms a composite with the organic-inorganic perovskite compound region, a more complicated composite film (a more intricately complicated structure) will be obtained, and photoelectric conversion efficiency will be increased. Therefore, the composite film is preferably formed on the porous second electron transport layer.

The thickness of the electron transport layer preferably has a lower limit of 1 nm and an upper limit of 2000 nm. Note that the thickness of the electron transport layer means the thickness of the first electron transport layer when only the first electron transport layer is used, and means the total of the thickness of the first and second electron transport layers when the second electron transport layer is used.

When the thickness of the electron transport layer is 1 nm or more, holes can be sufficiently blocked. When the thickness is 2000 nm or less, the thickness will hardly be the resistance in the case of electron transport, and photoelectric conversion efficiency will be increased. The thickness of the electron transport layer more preferably has a lower limit of 3 nm and an upper limit of 1000 nm, and further preferably has a lower limit of 5 nm and an upper limit of 500 nm.

### Photoelectric Conversion Layer;

The photoelectric conversion layer contains an organic-inorganic perovskite compound represented by the general formula R-M-X₃, where R represents an organic molecule; M represents a metal atom; and X represents a halogen atom or a chalcogen atom. The photoelectric conversion efficiency of the solar cell 1 can be improved by using the organic-inorganic perovskite compound for the photoelectric conversion layer.

The R is an organic molecule and preferably represented by ClNmHn, where all of l, m, and n are positive integers).

Specific examples of the R include methylamine, ethylamine, propylamine, butylamine, pentylamine, hexylamine, dimethylamine, diethylamine, dipropylamine, dibutylamine, dipentylamine, dihexylamine, trimethylamine, triethylamine, tripropylamine, tributylamine, tripentylamine, trihexylamine, ethylmethylamine, methylpropylamine, butylmethylamine, methylpentylamine, hexylmethylamine, ethylpropylamine, ethylbutylamine, imidazole, azole, pyrrole, aziridine, azirine, azetidine, azete, azole, imidazoline, and carbazole, and ions thereof (such as methylammonium (CH3NH3)), and phenethylammonium. Among them, methylamine, ethylamine, propylamine, butylamine, pentylamine, and hexylamines, and ions thereof, and phenethylammonium are preferred; and methylamine, ethylamine, and propylamine, and ions thereof are more preferred.

The M is a metal atom, and examples include lead, tin, zinc, titanium, antimony, bismuth, nickel, iron, cobalt, silver, copper, gallium, germanium, magnesium, calcium, indium, aluminum, manganese, chromium, molybdenum, and europium. These metal atoms may be used singly or in combination of two or more kinds thereof.

The X is a halogen atom or a chalcogen atom, and examples include chlorine, bromine, iodine, sulfur, and selenium. The halogen atom or chalcogen atom may be used singly or in combination of two or more kinds thereof. Among them, the halogen atom is preferred because when halogen is contained in the structure, the organic-inorganic perovskite compound is soluble in an organic solvent, and the application to an inexpensive printing method or the like is achieved. Further, iodine is more preferred because the energy band gap of the organic-inorganic perovskite compound becomes narrow.

The organic-inorganic perovskite compound preferably has a cubic structure in which the metal atom M is arranged at the body center; the organic molecule R is arranged at each vertex; and the halogen atom or the chalcogen atom X is arranged at a face center.

In addition to the organic-inorganic perovskite compound, the photoelectric conversion layer may further contain an organic semiconductor or an inorganic semiconductor in the range that does not impair the effect of the present invention. Note that the organic semiconductor or the inorganic semiconductor as described herein may play a role of the electron transport layer or the hole transport layer.

Examples of the organic semiconductor include a compound having a thiophene skeleton such as poly(3-alkylthiophene). Further examples also include conductive polymers and the like each having a poly(para-phenylenevinylene) skeleton, a polyvinylcarbazole skeleton, a polyaniline skeleton, or a polyacethylene skeleton etc. Further examples also include compounds each having a phthalocyanine skeleton, a naphthalocyanine skeleton, a pentacene skeleton, a porphyrin skeleton such as a benzoporphyrin skeleton, and a spirobifluorene skeleton, and a carbon-containing material such as a carbon nanotube, graphene, and fullerene, which may be surface-modified.

Examples of the inorganic semiconductor include titanium oxide, zinc oxide, indium oxide, tin oxide, gallium oxide, tin sulfide, indium sulfide, zinc sulfide, CuSCN, Cu₂O, CuI, MoO₃, V₂O₅, WO₃, MoS₂, MoSe₂, and Cu₂S.

When the photoelectric conversion layer contains the organic semiconductor or the inorganic semiconductor, the photoelectric conversion layer may be a laminate in which a thin film-shaped organic semiconductor or inorganic semiconductor region and a thin film-shaped organic-inorganic perovskite compound region are laminated, or may be a composite film in which the organic semiconductor or inorganic semiconductor region forms a composite with the organic-inorganic perovskite compound region. A laminate film is preferred in terms of easy manufacturing method, and a composite film is preferred in terms of capable of improving the charge separation efficiency in the organic semiconductor or the inorganic semiconductor.

The thickness of the thin film-shaped organic-inorganic perovskite compound region preferably has a lower limit of 5 nm and an upper limit of 5000 nm. When the thickness is 5 nm or more, light can be sufficiently absorbed, and photoelectric conversion efficiency will be increased. When the thickness is 5000 nm or less, the occurrence of a region in which charge cannot be separated can be suppressed, thereby leading to an improvement in photoelectric conversion efficiency. The thickness more preferably has a lower limit of 10 nm and an upper limit of 1000 nm, and further preferably has a lower limit of 20 nm and an upper limit of 500 nm.

### Hole Transport Layer;

Examples of the material for the hole transport layer include, but are not particularly limited to, a P-type conductive polymer, a P-type low-molecular organic semiconductor, a P-type metal oxide, a P-type metal sulfide, and a surfactant. Specific examples include a polystyrene sulfonate adduct of polyethylene dioxythiophene, carboxyl group-containing polythiophene, phthalocyanine, porphyrin, molybdenum oxide, vanadium oxide, tungsten oxide, nickel oxide, copper oxide, tin oxide, molybdenum sulfide, tungsten sulfide, copper sulfide, tin sulfide, fluoro group-containing phosphonic acid, carbonyl group-containing phosphonic acid, a copper compound such as CuSCN and CuI, and a carbon-containing material such as a carbon nanotube and graphene, which may be surface-modified.

The thickness of the hole transport layer preferably has a lower limit of 1 nm and an upper limit of 2000 nm. When the thickness is 1 nm or more, electrons can sufficiently be blocked. When the thickness is 2000 nm or less, the thickness will hardly be the resistance in the case of hole transport, and photoelectric conversion efficiency will be increased. The thickness of the hole transport layer more preferably has a lower limit of 3 nm and an upper limit of 1000 nm, and further preferably has a lower limit of 5 nm and an upper limit of 500 nm.

### Resin Layer;

The resin layer is a flattening layer provided for flattening the upper surface of the solar cell. The resin constituting the resin layer may be, but is not particularly limited to, a thermoplastic resin, a thermosetting resin, or a photocurable resin.

Examples of the thermoplastic resin include butyl rubber, polyester, polyurethane, polyethylene, polypropylene, polyvinyl chloride, polystyrene, polyvinyl alcohol, polyvinyl acetate, ABS resin, polybutadiene, polyamide, polycarbonate, polyimide, polyisobutylene, cycloolefin resin and the like.

Examples of the thermosetting resin include epoxy resin, acrylic resin, silicone resin, phenolic resin, melamine resin, urea resin and the like.

Examples of the photocurable resin include epoxy resin, acrylic resin, vinyl resin, ene-thiol resin and the like. A resin having an alicyclic skeleton is preferred.

Examples of a method for forming the resin layer include, but are not particularly limited to, screen printing, gravure printing, offset gravure, and flexographic printing.

The thickness of the resin layer is smaller than the thickness of the auxiliary wirings. The thickness of the resin layer can be, for example, 0.1 µm to 5 µm.

The resin layer may contain a wiring corrosion inhibitor. In this case, the corrosion of the auxiliary wirings can be much more suppressed. Examples of the wiring corrosion inhibitor that can be used include, but are not particularly limited to, azoles such as imidazole-based, triazole-based, tetrazole-based, oxazole-based, and thiadiazole-based compounds, thiols such as alkylthiol-based, thioglycolic acid derivative-based, and mercaptopropionic acid derivative-based compounds, thioethers, tetrazaindene-based compounds, pyrimidine-based compounds, and triazine-based compounds.

### Inorganic Layer;

The inorganic layer is a barrier layer for suppressing the infiltration of water vapor into the inner part. The material constituting the inorganic layer is a conductive material. As long as they are conductive examples of the material constituting the inorganic layer preferably include, but are not particularly limited to, a metal oxide, a metal nitride, and a metal oxynitride.

Examples of the metal in the metal oxide, the metal nitride or the metal oxide include, but are not particularly limited to, Si, Al, Zn, Sn, In, Ti, Mg, Zr, Ni, Ta, W, Cu, and alloys using these metals as the main component. Among them, a metal oxide and a metal nitride each containing Si, Al, Zn, or Sn are preferred.

When a metal oxide and a metal nitride each containing Si or Al are used, gas barrier properties can be further increased. When a metal oxide and a metal nitride each containing Zn and Sn are used, flexibility can be much more increased.

Therefore, it is more preferred to use a metal oxide and a metal nitride each containing at least one of Si and Al, Zn, and Sn.

From the point of view of suppressing a reduction in light transmittance, a refractive index gradient film, in which the refractive index continuously changes from n1 to n2 (n1 < n2) from one surface toward the other surface, may be used as the inorganic layer. Examples of the refractive index gradient film include SiZnSnO in which the refractive index can be changed from n1 = 1.51 to n2 = 1.91.

Examples of a method for forming the inorganic layer include, but are not particularly limited to, a sputtering method, a vapor deposition method, an ion plating method, a CVD method, an ALD method, a spray CVD method, and a mist CVD method.

The thickness of the inorganic layer is, but not particularly limited to, preferably 30 nm to 3 µm, more preferably 50 nm to 1 µm.

### Auxiliary Wirings, First and Second Terminals;

The materials constituting the auxiliary wirings and the first and second terminals are not particularly limited as long as the materials are conductive materials. A metal such as Cu and Ag or an alloy is preferably used. By using such a metal or an alloy, the cost can be reduced, and the electric resistance of an electrically connected part can be reduced, thus capable of taking out larger electric power.

Examples of a method for forming the auxiliary wirings and the first and the second terminals include, but are not particularly limited to, screen printing, gravure printing, offset gravure, flexographic printing, photolithography, an ink-jet, or a dispenser.

Thickness of the auxiliary wirings can be, for example, but is not particularly limited to, 1 to 10 µm.

The auxiliary wirings preferably have a grid planar shape. In this case, the line width of the auxiliary wirings is preferably 10 µm to 5 mm, and the interval between each auxiliary wiring is preferably 50 µm to 20 mm.

### Insulating Layer;

The insulating material constituting the insulating layer is not particularly limited. That is, an organic insulating material may be used. An inorganic insulating material may also be used. Examples of such an inorganic insulating material include inorganic oxides such as SiO₂, Al₂O₃, and ZrO, glass, and Claist. An organic insulating material may be used as long as it has sufficiently satisfactory heat resistance. Examples of such an organic insulating material include thermosetting polyimide and the like.

The insulating layer can be formed by printing and baking the insulating material on the first electrode. However, a method forming the insulating layer is not limited to the above method. As the printing method, a suitable printing method can be used, such as screen printing, gravure printing, offset gravure printing, and flexographic printing.

The size of the insulating layer is not particularly limited. The height of the insulating layer is desirably about 1 µm to 10 µm, and the width thereof is desirably about 50 µm to 5 mm, more preferably about 100 µm to 3 mm.

As described above, the present invention has a feature of providing the auxiliary wirings of a photovoltaic cell so as to be filled with the resin layer. Therefore, the lamination form of each part of the photovoltaic cell and the material of each layer are not particularly limited. Consequently, the constitution of the photovoltaic cell part itself in the solar cell of the present invention can be arbitrarily modified.

### Reference Signs List

1, 21, 31 ... Solar cell
2 ... First electrode
3 ... First electron transport layer
4 ... Second electron transport layer
5 ... Photoelectric conversion layer
6 ... Hole transport layer
7 ... Second electrode
8, 8A, 8B ... Auxiliary wirings
9 ... Resin layer
10 ... Inorganic layer
11, 12 ... First and second terminals
13 ... Insulating layer

## Claims

1. A solar cell comprising:
a first electrode (2);
a second electrode (7) arranged so as to face the first electrode;
a photoelectric conversion layer (5) which is arranged between the first electrode and the second electrode and contains an organic-inorganic perovskite compound;
a plurality of auxiliary wirings (8) provided on the second electrode;
a resin layer (9) provided on the second electrode so as to fill a space between the plurality of auxiliary wirings;
an inorganic layer (10) provided so as to cover the plurality of auxiliary wirings and the resin layer, a first terminal (11) connected to the first electrode and a second terminal (12) connected to the plurality of auxiliary wirings,
**characterized in that**
the thickness of the plurality of auxiliary wirings is larger than the thickness of the resin layer, and
the inorganic layer is constituted by a conductive material, and the second terminal is provided on the inorganic layer.

2. The solar cell according to claim 1, wherein
the second electrode (7) forms a laminated structure directly or indirectly laminated on the photoelectric conversion layer (5), and
the solar cell further comprises an insulating layer (13) provided so as to cover an outer peripheral surface of the laminated structure.

3. The solar cell according to any one of claims 1 or 2, wherein the organic-inorganic perovskite compound is represented by the general formula R-M-X₃, where R represents an organic molecule; M represents a metal atom; and X represents a halogen atom or a chalcogen atom.

4. The solar cell according to any one of claims 1 to 3, wherein the resin layer contains a wiring corrosion inhibitor.

5. The solar cell according to any one of claims 1 to 4, wherein the first electrode is constituted by metal foil.

6. The solar cell according to any one of claims 1 to 5, further comprising an electron transport layer arranged between the first electrode and the photoelectric conversion layer and a hole transport layer arranged between the photoelectric conversion layer and the second electrode.

## Patentansprüche

1. Solarzelle, umfassend:
eine erste Elektrode (2);
eine zweite Elektrode (7), die so angeordnet ist, dass sie der ersten Elektrode gegenüberliegt;
eine photoelektrische Konversionsschicht (5), die zwischen der ersten Elektrode und der zweiten Elektrode angeordnet ist und eine organisch-anorganische Perowskitverbindung enthält;
eine Vielzahl von Hilfsverdrahtungen (8), die auf der zweiten Elektrode vorgesehen sind;
eine Harzschicht (9), die auf der zweiten Elektrode vorgesehen ist, um einen Raum zwischen der Vielzahl von Hilfsverdrahtungen auszufüllen;
eine anorganische Schicht (10), die so vorgesehen ist, dass sie die Vielzahl von Hilfsverdrahtungen und die Harzschicht bedeckt,
einen ersten Anschluss (11), der mit der ersten Elektrode verbunden ist, und einen zweiten Anschluss (12), der mit der Vielzahl von Hilfsverdrahtungen verbunden ist,
**dadurch gekennzeichnet, dass**
die Dicke der Vielzahl von Hilfsverdrahtungen größer ist als die Dicke der Harzschicht, und
die anorganische Schicht aus einem leitfähigen Material besteht und der zweite Anschluss auf der anorganischen Schicht vorgesehen ist.

2. Solarzelle nach Anspruch 1, wobei
die zweite Elektrode (7) eine laminierte Struktur bildet, die direkt oder indirekt auf die photoelektrische Konversionsschicht (5) laminiert ist, und
die Solarzelle ferner eine Isolierschicht (13) umfasst, die so vorgesehen ist, dass sie eine äußere Umfangsfläche der laminierten Struktur bedeckt.

3. Solarzelle nach einem der Ansprüche 1 oder 2, wobei die organisch-anorganische Perowskitverbindung durch die allgemeine Formel R-M-X₃ dargestellt wird, wobei R ein organisches Molekül darstellt; M ein Metallatom darstellt; und X ein Halogenatom oder ein Chalkogenatom darstellt.

4. Solarzelle nach einem der Ansprüche 1 bis 3, wobei die Harzschicht einen Korrosionsinhibitor für die Verdrahtung enthält.

5. Solarzelle nach einem der Ansprüche 1 bis 4, wobei die erste Elektrode aus einer Metallfolie besteht.

6. Solarzelle nach einem der Ansprüche 1 bis 5, ferner umfassend eine zwischen der ersten Elektrode und der photoelektrischen Konversionsschicht angeordnete Elektronentransportschicht und eine zwischen der photoelektrischen Konversionsschicht und der zweiten Elektrode angeordnete Lochtransportschicht.

## Revendications

1. Cellule solaire comportant :
une première électrode (2) ;
une seconde électrode (7) disposée de manière à faire face à la première électrode ;
une couche de conversion photoélectrique (5) qui est disposée entre la première électrode et la seconde électrode et contient un composé de pérovskite organique-inorganique ;
une pluralité de câblages auxiliaires (8) agencés sur la seconde électrode ;
une couche de résine (9) agencée sur la seconde électrode de manière à remplir un espace entre la pluralité de câblages auxiliaires ;
une couche inorganique (10) disposée de manière à recouvrir la pluralité de agencée auxiliaires et la couche de résine,
une première borne (11) connectée à la première électrode et une seconde borne (12) connectée à la pluralité de câblages auxiliaires,
**caractérisée en ce que**
l'épaisseur de la pluralité de câblages auxiliaires est supérieure à l'épaisseur de la couche de résine, et
la couche inorganique est constituée d'un matériau conducteur, et la seconde borne est agencée sur la couche inorganique.

2. Cellule solaire selon la revendication 1, dans laquelle
la seconde électrode (7) forme une structure stratifiée directement ou indirectement stratifiée sur la couche de conversion photoélectrique (5), et
la cellule solaire comporte en outre une couche isolante (13) agencée de manière à recouvrir une surface périphérique extérieure de la structure stratifiée.

3. Cellule solaire selon l'une quelconque des revendications 1 ou 2, dans laquelle le composé de pérovskite organique-inorganique est représenté par la formule générale R-M-X₃, où R représente une molécule organique ; M représente un atome de métal ; et X représente un atome d'halogène ou un atome de chalcogène.

4. Cellule solaire selon l'une quelconque des revendications 1 à 3, dans laquelle la couche de résine contient un inhibiteur de corrosion de câblage.

5. Cellule solaire selon l'une quelconque des revendications 1 à 4, dans laquelle la première électrode est constituée d'une feuille de métal.

6. Cellule solaire selon l'une quelconque des revendications 1 à 5, comportant en outre une couche de transport d'électrons disposée entre la première électrode et la couche de conversion photoélectrique, et une couche de transport de trous disposée entre la couche de conversion photoélectrique et la seconde électrode.
